# EUROPÄISCHE PATENTSCHRIFT

(11) **EP 1 129 493 B1**
(45) Veröffentlichungstag und Bekanntmachung des Hinweises auf die Patenterteilung: **11.06.2008**
(21) Anmeldenummer: 00958212.3
(22) Anmeldetag: 03.08.2000
(51) Int. Cl.: H01L 41/083

(54) **PIEZOKERAMISCHE VIELSCHICHTSTRUKTUR MIT REGELMÄSSIGER POLYGON-QUERSCHNITTSFLÄCHE**
PIEZOCERAMIC MULTI-LAYER STRUCTURE WITH REGULAR POLYGON CROSS-SECTIONAL AREA
STRUCTURE MULTICOUCHE PIEZOCERAMIQUE PRESENTANT UNE SURFACE DE SECTION POLYGONALE

(30) Priorität: 28.08.1999 DE 19941044
(43) Veröffentlichungstag der Anmeldung: 05.09.2001
(73) Patentinhaber: ROBERT BOSCH GMBH, 70442 Stuttgart (DE)
(72) Erfinder: HENNECK, Stefan, D-70839 Gerlingen (DE)
(86) Internationale Anmeldenummer: PCT/DE2000/002587
(87) Internationale Veröffentlichungsnummer: WO 2001/017038

(56) Entgegenhaltungen:
- EP-A- 0 977 284
- WO-A-96/30935
- WO-A-97/36365
- PATENT ABSTRACTS OF JAPAN vol. 016, no. 318 (E-1232), 13. Juli 1992 (1992-07-13) & JP 04 091664 A (BROTHER IND LTD), 25. März 1992 (1992-03-25)

## Beschreibung

Die Erfindung betrifft einen piezoelektrischen Keramikkörper nach der Gattung des Hauptanspruches.

### Stand der Technik

Keramische Piezoaktoren, die aus einer Vielzahl von dünnen keramischen, piezoelektrischen Schichten bestehen, die jeweils über eine Elektrodenschicht voneinander getrennt und darüber elektrisch kontaktierbar und ansteuerbar sind, sind vielfach bekannt. Dazu sei beispielsweise auf K. Ruschmeyer, "Piezokeramik: Grundlagen, Werkstoff, Applikationen", expert-Verlag, Renningen, 1995, und insbesondere die dortigen Seiten 36 bis 45 verwiesen.

Bekannte Piezoaktoren bestehen demnach beispielsweise aus einer PZT-Keramik, d.h. Pb(TiₓZr_{y})O₃ mit 0,40 < x < 0,60, als keramische, piezoaktive Schichten, die über dazwischen angebrachte Innenelektroden aus einer Ag/Pd-Legierung oder Pt ansteuerbar sind.

Weiter werden diese keramischen Piezoaktoren bisher in Quaderform mit quadratischer Grundfläche ausgeführt, wobei verschiedene Möglichkeiten zur Ausführung der Innenelektroden bestehen, die einerseits eine sichere elektrische Isolation benachbarter Piezokeramikschichten gewährleisten und gleichzeitig innere Spannungen in dem Keramikkörper bei Betrieb minimieren sollen.

Beispielsweise ist aus JP 04091664 A ein piezoelektrisches Element bekannt, das aus mehreren piezoelektrischen keramischen Schichten mit dazwischen angeordneten Elektrodenschichten aufgebaut ist. In Draufsicht weist das piezoelektrische Element die Form eines 8-Eckes auf.

### Vorteile der Erfindung

Der erfindungsgemäße piezoelektrische Keramikkörper wie in Ansprush 1 definiert, hat gegenüber dem Stand der Technik den Vorteil, daß damit eine gleichmäßigere Entbinderung des grünen Keramikkörpers nach dem Verpressen der einzelnen Schichten zu dem grünen Keramikkörper erzielt wird, da die Form des grünen Keramikkörpers bzw. der diese Form bestimmenden einzelnen Isolierschichten dazu führt, daß Unterschiede in der Entfernung von Massenelementen einer Schicht vom Schwerpunkt der Schicht verringert werden, wobei Kontaktbereiche und Totzonen am Rand des n-Eckes von Seite zu Seite vorteilhaft sich abwechseln. Dies gilt besonders im Fall eines regelmäßigen n-Eckes, das sich mit zunehmender Zahl der Ecken der Keramikkörpers zunehmend der Zylinderform nähert.

Weiterhin ergibt sich eine verbesserte Verteilung von mechanischen Spannungen in unvermeidbaren Totzonen der Isolierschichten insbesondere am Seitenrand des Keramikkörpers, die bei Anlegen einer elektrischen Spannung einer mechanischen Zugspannung ausgesetzt sind und von denen dadurch bevorzugt Risse ausgehen.

Weiter ist vorteilhaft, daß durch die Form beim Verpressen der einzelnen Schichten des Keramikkörpers in Form von Grünfolien auftretende Probleme hinsichtlich der Homogenität der Pressung vermindert werden. Dies beruht darauf, daß mit der Vergrößerung des Innenwinkels in den Ecken des n-Eckes, beispielsweise auf 120° im Fall des regelmäßigen Sechseckes, die Reibung in den Ecken beim Pressen in einer Matrize (Einsatzform) deutlich vermindert wird. Somit wird über eine verminderte Reibung eine gleichmäßigere Druckverteilung beim Laminieren bzw. der Pressung der Grünfolien zu einem danach zu dem Keramikkörper zu sinternden Grünkörper erzielt, was neben der gleichmäßigeren lateralen Verteilung der Zugspannung in den Totzonen der Isolierschichten insgesamt zu weniger Ausschuß in der Produktion und einer gleichmäßigeren Qualität und verlängerten Betriebs- bzw. Lebensdauer der erzeugten Keramikkörper führt.

Mechanische Spannungen in den Totzonen, d.h. den Zonen der Isolierschicht, die aufgrund in diesem Bereich fehlender Elektrodenflächen keine oder - durch Streufelder der Leitschichten - nur eine sehr geringe mechanische Dehnung oder Stauchung über den umgekehrten piezoelektrischen Effekt erfahren, führen regelmäßig dazu, daß von diesen Totzonen bevorzugt Risse ausgehen, die zu einem Auseinanderbrechen des Keramikkörpers führen können. Diese Rißbildung wird wesentlich durch inhomogene Zugspannungen in dem Keramikkörper gefördert.

Vorteilhafte Weiterbildungen der Erfindung ergeben sich aus den in den Unteransprüchen genannten Maßnahmen.

So hat sich als besonders vorteilhaft herausgestellt, wenn die Isolierschichten die Form eines regelmäßigen Sechs- oder Achteckes aufweisen.

In diesem Fall ist zunächst vorteilhaft eine Kontaktierung der Leitschichten unter einem Winkel von 120° bzw. 135° anstelle eines Winkels von 90° im Fall einer quadratischen Grundfläche möglich, wobei gleichzeitig auch die Anzahl möglicher Kontaktierungsvarianten durch die damit einhergehende Erhöhung der Anzahl der Seitenflächen des Keramikkörpers steigt. Auf diese Weise kann man somit vorteilhaft den erfindungsgemäßen Keramikkörper zunächst fertig herstellen und beispielsweise im Fall eines Achteckes zwei Vierergruppen von jeweils äquivalenten Seitenflächen erzeugen, die später mit äußeren, auf den Seitenflächen des Keramikkörpers angebrachten Elektroden zur elektrischen Ansteuerung der zwischen den Isolierschichten befindlichen Leitschichten kontaktierbar sind, und anschließend in einer nachgeschalteten Funktionsprüfung der fertigen Keramikkörper nach dem Sintern diejenige Kombination von zwei Seitenflächen aus jeweils einer der Vierergruppen aussuchen, die bei Kontaktierung mit den äußeren Elektroden die besten piezoelektrischen Eigenschaften (erzielte Dehnung bei vorgegebener Spannung, Minimierung von Kurzschlüssen usw.) aufweist.

Aufgrund der vermehrten Zahl von Seitenflächen der erfindungsgemäßen Form des erzeugten Keramikkörpers und einer Zahl von drei bzw. vier symmetrisch angeordneten, am äußeren Seitenrand der Isolierschichten befindlichen, möglichst schmalen Totzonen, die sich bevorzugt über den Bereich aller Ecken des regelmäßigen n-Eckes erstrecken, sowie gleichzeitig drei bzw. vier symmetrisch angeordneten Kontaktierungsmöglichkeiten der Leitschichten durch außen angebrachte Elektroden, ergibt sich eine besonders vorteilhafte, gleichmäßige Verteilung der Zugspannung in den Totzonen.

So ist die in den Totzonen auftretende Zugspannung, die besonders stark im Bereich der Ecken ist, im Fall eines Achteckes beispielsweise vorteilhaft symmetrisch auf acht Ecken und vier Seitenflächen verteilt.

Durch die erfindungsgemäße, insbesondere regelmäßige Anordnung der Leitschichten zwischen den Isolationsschichten aus der eigentlichen Piezokeramik kommt es weiter zu einer verbesserten räumlichen Trennung der nach dem Sintern des Keramikkörpers angebrachten äußeren Elektroden, die auf mindestens zwei Seitenflächen des prismenförmigen Keramikkörpers die Leitschichten jeweils abwechselnd elektrisch kontaktieren. Damit werden vorteilhaft Kurzschlüsse zwischen zwei aufeinanderfolgenden Leitschichten verhindert, die jeweils einer anderen äußeren Elektrode zugeordnet sind. Dies gilt besonders dann, wenn die Ecken der Isolierschichten und damit auch die Ecken des in Form eines Prismas erzeugten Keramikkörpers stets durch Totzonen gebildet werden, so daß in der Umgebung der Ecken keine Kontaktierung durch äußere Elektroden vorgenommen werden kann und eine gute räumliche Trennung der nach außen geführten Bereiche der Leitschichten zwischen benachbarten Seiten des regelmäßigen n-Eckes gewährleistet ist.

Im übrigen ergeben sich beispielsweise im Fall eines regelmäßigen Sechs- oder Achteckes, bei dem jede Leitschicht an drei bzw. vier symmetrisch angeordneten Seiten nach außen geführt ist und bei dem zwei aufeinanderfolgende Leitschichten gegeneinander um 60° bzw. 45° verdreht sind, vorteilhaft jeweils drei bzw. vier völlig äquivalente Seitenflächen des erzeugten senkrechten Prismas. Somit kann auch jede dieser Seitenflächen zur Ansteuerung der Leitschichten mit äußeren Elektroden versehen werden, wobei jeweils drei bzw. vier, aufgrund der Konstruktion ebenfalls symmetrisch angeordnete Elektroden gemeinsam mit einem Pol der äußeren Spannungsquelle, und entsprechend die verbliebenen drei bzw. vier Elektroden mit dem anderen Pol der äußeren Spannungsquelle kontaktiert sind. Damit hat man für jede Leitschicht vorteilhaft bis zu drei bzw. vier äquivalente und redundante Anschlußkontakte, so daß selbst dann wenn innerhalb einer Leitschicht ein Kontakt mit der zugeordneten äußeren Elektrode nach dem Sintern unzureichend ist, die Ansteuerung dieser Leitschicht automatisch über die übrigen Anschlußkontakte erfolgt.

Weiterhin ist vorteilhaft, daß auch das aus dem Stand der Technik bekannte Verschmierungsproblem bei dem erfindungsgemäßen Keramikkörper deutlich minimiert wird. Darunter versteht man, daß beim nachträglichen Schleifen der Keramikkörper nach dem Sintern, beispielsweise um die Kontaktierung der Leitschichten zu ermöglichen oder zu verbessern, eine Verschmierung von Elektrodenmaterial, beispielsweise Metall über die Seitenflächen des Keramikkörpers stattfindet, die dazu führt, daß benachbarte Leitschichten über die Seitenflächen des geschliffenen Quaders kurzgeschlossen werden. Dies wird bei dem erfindungsgemäßen Keramikkörper dadurch verhindert, daß die Umgebung der Ecken des n-Eckes stets aus dem Material der Isolierschichten besteht, d.h. als Totzone ausgebildet ist. Somit wird beim Schleifen einer Seitenfläche das dort vorhandene Metall aus den Leitschichten nur auf dieser Seitenfläche verschmiert, was teilweise sogar erwünscht, jedoch zumindest nicht schädlich ist, da ohnehin alle Leitschichten, die an der jeweiligen Seitenfläche derart ausgestaltet sind, daß sie bis zum Rand der jeweiligen Isolierschicht reichen, auf dieser Seitenfläche mit der selben äußeren Elektrode kontaktiert werden sollen. Beim Schleifen tritt somit zumindest nahezu keine unerwünschte Verschmierung "über Eck" auf, d.h. eine Verschleppung von Metall von einer Seitenfläche auf eine andere, da die Umgebung der Ecken von metallfreien, über die gesamte Höhe des Prismas isolierenden Totzonen gebildet ist.

Eine zu große Vermehrung der Zahl der Ecken des insbesondere regelmäßigen n-Eckes hat im übrigen auch Nachteile, da damit die zur Anbringung der äußeren Elektroden auf den Seitenflächen zur Verfügung stehende Fläche bei ansonsten gleichem Radius des Keramikkörpers zunehmend vermindert wird und die von den Totzonen eingenommene Fläche bezogen auf die gesamte Seitenfläche steigt.

Eine optimale Zahl von Ecken liegt zwischen fünf und zehn. Im vorliegenden fall beträgt die Eckenzahl sechs, acht oder zehn.

Die Anzahl der Seiten des n-Eckes, bei denen eine Totzone den Rand der Isolierschicht bildet, ist dabei gleich der Anzahl der Seiten des n-Eckes, mit einem Kontaktbereich, d.h. einem Bereich in dem die Leitschicht die darunterliegende Isolierschicht bis zum Rand bedeckt, gewählt werden kann. Dabei wechseln sich Kontaktbereiche und Totzonen am Rand des n-Eckes von Seite zu Seiten vorteilhaft ab.

Somit ergibt sich durch den im Querschnitt absolut symmetrischen Aufbau des erzeugten Keramikkörpers ein guter Kompromiß zwischen Spannungsverteilung, zur Verfügung stehender Seitenfläche, Totzonenfläche, Zahl der Anschlußmöglichkeiten und Homogenität beim Laminieren bzw. Pressen.

Außerdem ist im Fall eines regelmäßigen n-Eckes die Form der Leitschichten auf den Isolierschichten vorteilhaft jeweils von Leitschicht zu Leitschicht prinzipiell gleich, wobei benachbarte Leitschichten jedoch gegeneinander um einen Winkel gedreht aufgebracht werden, der 360°/n entspricht.

Diese Drehung kann in der Produktion bei vollständig symmetrischem Aufbau der Leitschichten bei einem regelmäßigen n-Eck vorteilhaft stets gleichsinnig erfolgen.

Eine zylindrische Form des Keramikkörpers als Grenzfall eines regelmäßigen n-Eckes mit einer sehr großen Zahl von Ecken ist im übrigen unzweckmäßig, da dadurch zusätzliche Probleme bei der Justage, beim definierten Aufbringen der übereinanderliegenden Schichten und der Kontaktierung der äußeren Elektroden entstehen. Außerdem ist das Schleifen der Mantel- bzw. Seitenfläche bei zylindrischen Formen deutlich aufwendiger und schwieriger als bei einem Prisma.

### Zeichnung

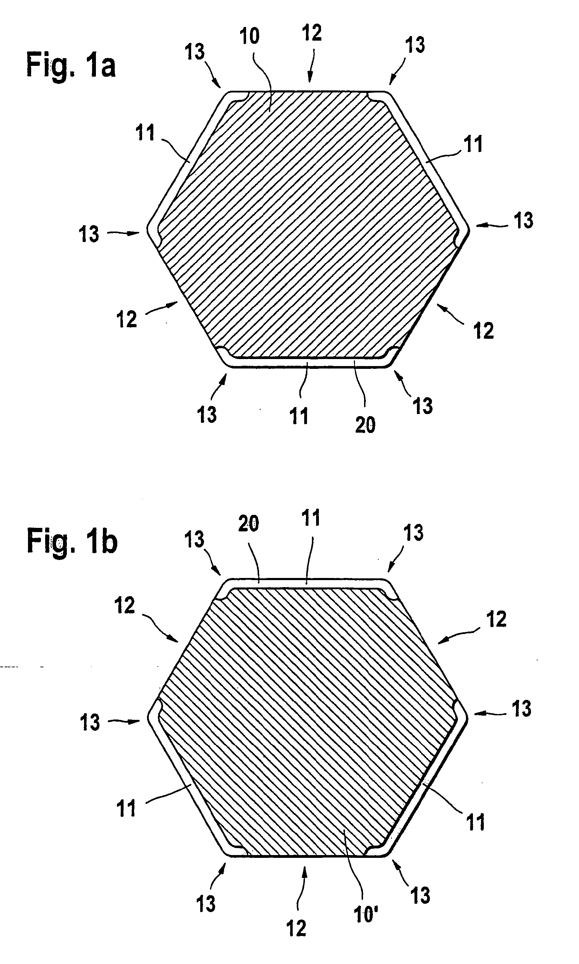

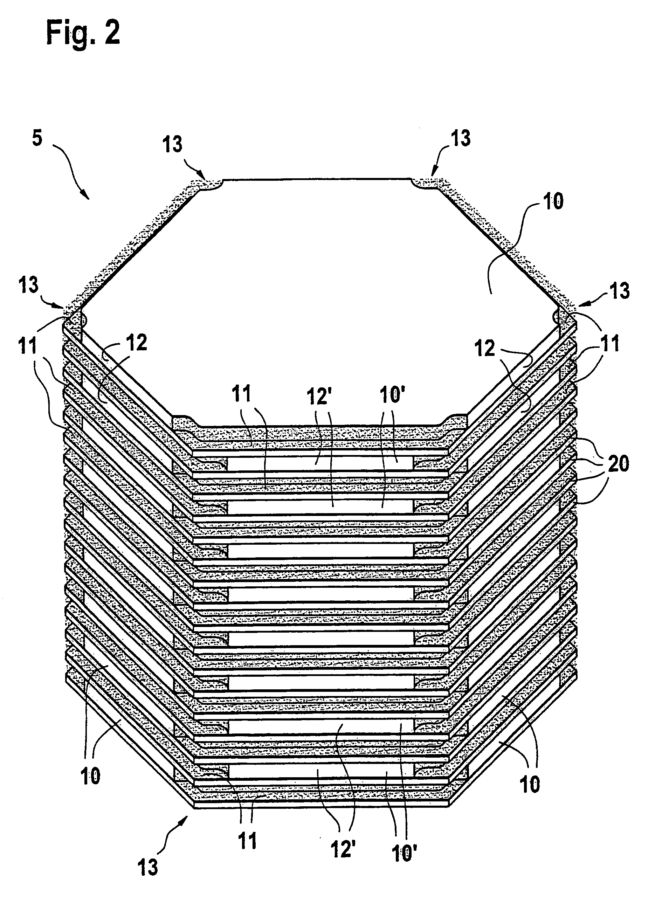

Ausführungsbeispiele der Erfindung werden anhand der Zeichnungen und in der nachfolgenden Beschreibung näher erläutert. Es zeigen Figur 1a und Figur 1b zwei innerhalb der Schichtfolge des Keramikkörpers aufeinanderfolgende, jeweils mit einer Leitschicht versehene Isolierschichten in Draufsicht und Figur 2 den gesamten piezoelektrischen Keramikkörper.

### Ausführungsbeispiele

Die Figur 1a zeigt eine dünne Isolierschicht 20 aus einer an sich bekannten PZT-Keramik in Form eines regelmäßigen Sechseckes mit sechs gleichen Seiten 12, wobei die Ecken des Sechseckes zusätzlich leicht verrundet sind. Die PZT-Keramik hat beispielsweise die Zusammensetzung Pb(TiₓZr_{y})O₃ mit 0,40 < x < 0,60. Die Dicke der Isolierschicht 20 beträgt beispielsweise 50 µm bis 150 µm. Weiter ist auf der Isolierschicht 20 eine erste Leitschicht 10 aus einer an sich bekannten metallischen Ag/Pd-Legierung oder aus Pt aufgebracht. Das Aufbringen der ersten Leitschicht 10 auf die Isolierschicht 20 erfolgte beispielsweise über ein Siebdruckverfahren, ihre Dicke beträgt beispielsweise 500 nm bis 5 µm, bevorzugt 1 µm bis 3 µm.

Weiter ist die erste Leitschicht 10 derart auf die Isolierschicht 20 aufgebracht, daß Totzonen 11 entstehen, die nicht von der ersten Leitschicht 10 bedeckt werden, d.h. im Bereich der Totzonen 11 ist die Oberfläche der Isolierschicht 20 zunächst weiter frei zugänglich. Die Totzonen 11 befinden sich symmetrisch angeordnet am Rand der Isolierschicht 20 und bilden drei Seitenränder des Sechseckes. Ihre Breite beträgt typischerweise 30 µm bis 1 mm, bevorzugt 100 µm bis 400 µm. Die Isolierschicht 20 nimmt im übrigen im erläuterten Beispiel eine Fläche von ca. 100 mm² ein. Der Radius in den verrundeten Kanten beträgt ca. 0,5 mm.

Aufgrund der Form der ersten Leitschicht 10 ist diese im Bereich von drei Seiten 12 des Sechseckes bis zum Rand des Sechseckes ausgedehnt und überdeckt dort entlang des Seitenrandes auf einer Länge von beispielsweise 4,2 mm die Isolierschicht 20 vollständig, so daß dort ein Kontaktbereich entsteht.

Die Figur 1b zeigt eine gegenüber der Figur 1a völlig analog aufgebaute Schichtanordnung aus der Isolierschicht 20 und einer zweiten Leitschicht 10', die sich von der ersten Leitschicht 10 nur dadurch unterscheidet, daß die zweite Leitschicht 10' dieser gegenüber um 60° gedreht aufgebracht ist.

Die Figur 2 zeigt den vollständigen Aufbau eines piezoelektrischen Keramikkörpers 5 aus einer an sich bekannten periodischen Abfolge einer Vielzahl von Isolierschichten 20 und Leitschichten 10 bzw. 10' im grünen Zustand vor dem Pressen. Insgesamt weist der Keramikkörper 5 ca. 200 bis 500 Isolierschichten 20 auf. Es sei dabei betont, daß in Figur 2 die Dicke der Leitschichten 10, 10' gegenüber der Dicke der Isolierschichten 20 aus Gründen der Übersichtlichkeit deutlich überhöht dargestellt ist.

Der Keramikkörper 5 besteht somit im einzelnen aus einem Stapel der in Figur 1a bzw. 1b dargestellten Schichtpaare, die abwechselnd aufeinander geschichtet sind. Die Schichtfolge ist somit: Isolierschicht 20, erste Leitschicht 10, Isolierschicht 20, zweite Leitschicht 10', Isolierschicht 20, erste Leitschicht 10, usw..

Weiterhin ist in den Figuren 1a, 1b und 2 ersichtlich, daß in allen Eckbereichen 13 der Isolierschicht 20 die Isolierschicht 20 jeweils nicht von einer Leitschicht 10, 10' bedeckt ist, so daß dort stets eine Totzone 11 vorliegt. Unter einem Eckbereich 13 wird dabei im Sinne der Erfindung ein Randstreifen der Isolierschicht 20 verstanden, der eine typische Breite von 30 µm bis 1 mm, bevorzugt 100 µm bis 400 µm, hat, und der sich, ausgehend von einer Ecke der Isolierschicht 20, in jede der beiden der Ecke benachbarten Seiten 12 zumindest auf einer Länge von 5% bis 30% der jeweiligen Länge der Seiten 12 erstreckt.

Der an sich bekannte Herstellungsprozeß des Keramikkörpers 5 sieht kurz zusammengefaßt dazu vor, daß zunächst die Isolierschichten 20 in Form von keramischen Grünfolien in die gewünschte Form gebracht, anschließend mit den Leitschichten 10, 10' in der gewünschten Weise bedruckt, zu einem Grünkörper gemäß entsprechend Figur 2 gestapelt, anschließend in einer Matrize laminiert oder verpreßt, und schließlich bei 1000 C bis 1300°C zu dem Keramikkörper 5 gesintert werden.

Beim Laminieren bzw. Pressen des zunächst vor dem Sintern im grünen Zustand befindlichen Keramikkörpers 5 werden somit dessen Schichten 10, 10', 20 derart komprimiert, daß die unbedruckten Bereiche, d.h. die Totzonen 11, sich miteinander verbinden. Die in Figur 2 gepunktet dargestellten, oben und unten durch Totzonen 11 begrenzten schlitzförmigen Hohlräume in den durch die Leitschichten 10, 10' gebildeten Schichten des Keramikkörpers 5 werden somit durch das Material der Isolierschichten 20 zumindest weitgehend ausgefüllt. Die Leitschichten 10, 10' werden dabei gleichzeitig in die Isolierschichten 20 eingepreßt und von diesen umschlossen.

Beim Verpressen bzw. Laminieren kommen daher die Isolierschichten 20 im Bereich der Totzonen 11 direkt in Kontakt miteinander und sintern später dort zusammen.

Nach dem Sintern wird der erhaltene Keramikkörper 5 üblicherweise außen geschliffen und danach auf den entstandenen Seitenflächen 12', 12'' des erzeugten Prismas mit äußeren Elektroden kontaktiert. Dabei kontaktiert jeweils eine äußere Elektroden elektrisch entweder die bereichsweise über die jeweilige Seitenfläche 12', 12" des Keramikkörpers 5 zugänglichen Stirnflächen der ersten Leitschichten 10 oder der zweiten Leitschicht 10' auf dieser Seitenfläche 12', 12''. Dies ist möglich, da die Leitschichten 10, 10' auf den Seitenflächen 12', 12" bereichsweise jeweils bis zum Rand des Keramikkörpers 5 reichen.

Aufgrund des abwechselnden Aufbringens der ersten bzw. zweiten Leitschicht 10, 10' bilden die erste und zweite Leitschicht 10, 10' mit der jeweils dazwischen befindlichen Isolierschicht 20 einen Plattenkondensator mit der aus einem piezokeramischen Material bestehenden Isolierschicht 20 als Dielektrikum.

Im einzelnen erfolgt die Kontaktierung mit beispielsweise sechs flächig in an sich bekannter Weise auf die Seitenflächen 12', 12'' des Keramikkörpers 5 aufgebrachten äußeren Elektroden derart, daß drei der sechs Elektroden als erste Elektroden auf ersten Seitenflächen 12' des Keramikkörpers 5 aufgebracht sind, und die übrigen drei Elektroden als zweite Elektroden auf zweiten Seitenflächen 12". Die ersten Elektroden sind weiter miteinander und mit einem Pol einer Gleichspannungsquelle verbunden, während die zweiten Elektroden ebenfalls untereinander und mit dem anderen Pol der Gleichspannungsquelle verbunden sind. Bei Anlegen eines elektrischen Feldes von beispielsweise 1 kV/mm bis 3 kV/mm an die Elektroden wird daher innerhalb der einzelnen in dem Keramikkörper 5 erzeugten Kondensatoren über den umgekehrten piezoelektrischen Effekt eine Dehnung oder Stauchung des Keramikkörpers 5 bewirkt. Da im Bereich der Totzonen 11 keine Leitschichten 10, 10' vorliegen, ändert sich im Bereich der Totzonen 11 die Längenausdehnung nur geringfügig.

Das erläuterte Ausführungsbeispiel kann ohne weiteres auch auf andere piezokeramische Materialien neben PZT-Keramik oder Elektrodenmaterialien neben der Ag/Pd-Legierung übertragen werden. Auch die Form des Keramikkörpers 5 als Prima mit einer Grundfläche in Form eines regelmäßigen Sechseckes kann ohne weiteres auch auf ein Prisma mit einer acht- oder zehneckigen Grundfläche übertragen werden.

Weiterhin sei betont, daß es ausreichend ist, wenn lediglich zwei nicht äquivalente Seitenflächen 12', 12" gemäß Figur 2 mit äußeren Elektroden zur Ansteuerung der Leitschichten 10, 10' versehen sind. Dazu reicht es aus, wenn eine Seitenfläche 12' und eine Seitenfläche 12" eine äußere Elektrode aufweist.

### Bezugszeichenliste

- 5: Keramikkörper

- 10: erste Leitschicht
- 10`: zweite Leitschicht
- 11: Totzone
- 12: Seite
- 12': erste Seitenfläche
- 12'': zweite Seitenfläche
- 13: Eckbereich

- 20: Isolierschicht

## Patentansprüche

1. Piezoelektrischer Keramikkörper mit einer Mehrzahl von übereinander angeordneten Isolierschichten (20) mit einem piezokeramischen Material, wobei die Isolierschichten (20) zumindest bereichsweise voneinander durch eine Leitschicht (10, 10') mit einem Elektrodenmaterial getrennt sind, wobei zumindest die Isolierschichten (20) in Draufsicht zumindest näherungsweise die Form eines n-Eckes aufweisen, wobei n gleich sechs, acht oder zehn ist, und wobei die Leitschichten (10, 10') die Isolierschichten (20) jeweils derart weitgehend bedecken, dass zwei benachbarte Isolierschichten (20) nur im Bereich von schmalen, bereichsweise am äußeren Rand der Isolierschichten (20) befindlichen Totzonen (11) in direktem Kontakt zueinander sind, **dadurch gekennzeichnet, dass** die Anzahl der Seiten mit einer Totzone (11) am Rand des n-Eckes gleich der Anzahl der Seiten mit einem Kontaktbereich (12) ist, wobei sich Kontaktbereiche (12) und Totzonen (11) von Seite zu Seite abwechseln.

2. Piezoelektrischer Keramikkörper nach Anspruch 1, **dadurch gekennzeichnet, dass** das n-Eck zumindest näherungsweise ein regelmäßiges n-Eck.ist.

3. Piezoelektrischer Keramikkörper nach Anspruch 1, **dadurch gekennzeichnet, dass** die Ecken des n-Eckes zumindest teilweise verrundet sind.

4. Piezoelektrischer Keramikkörper nach Anspruch 1, **dadurch gekennzeichnet, dass** die übereinander angeordneten Isolierschichten (20) einen Keramikkörper (5) in Form eines senkrechten Prismas ergeben.

5. Piezoelektrischer Keramikkörper nach Anspruch 1, **dadurch gekennzeichnet, dass** die Leitschichten (10, 10') die Isolierschichten (20) jeweils derart weitgehend bedecken, dass die Leitschichten (10, 10') bereichsweise bis zum Rand der Isolierschichten (20) reichen.

6. Piezoelektrischer Keramikkörper nach Anspruch 1, **dadurch gekennzeichnet, dass** die Leitschicht (10, 10') die darunter befindliche Isolierschicht (20) jeweils derart weitgehend bedeckt, dass die Leitschicht (10, 10') zumindest im Bereich einer Seite (12) des von der Isolierschicht (20) gebildeten n-Eckes, bis zum Rand des n-Eckes reicht, und dass zumindest im Bereich der beiden zu der Seite des n-Eckes benachbarten Seiten (12) des n-Eckes der Rand der Isolierschicht (20) durch eine Totzone (11) gebildet ist.

7. Piezoelektrischer Keramikkörper nach Anspruch 1 oder 6, **dadurch gekennzeichnet, dass** die Totzone (11) eine Breite von 30 µm bis 1 mm, insbesondere 100 µm bis 400 µm hat.

8. Piezoelektrischer Keramikkörper nach mindestens einem der vorangehenden Ansprüche, **dadurch gekennzeichnet, dass** die Leitschichten (10, 10') zwischen den Isolierschichten (20) derart ausgebildet sind, dass eine auf einer Seitenfläche (12') des von dem Keramikkörper (5) gebildeten Prismas angebrachte erste Elektrode jeweils nur mit jeder zweiten Leitschicht (10') elektrisch leitend in Verbindung steht, und dass eine auf einer anderen Seitenfläche (12") des von dem Keramikkörper (5) gebildeten Prismas angebrachte zweite Elektrode jeweils nur mit den verbleibenden, nicht mittels der ersten Elektrode kontaktierten Leitschichten (10) elektrisch leitend in Verbindung steht.

9. Piezoelektrischer Keramikkörper nach mindestens einem der vorangehenden Ansprüche, **dadurch gekennzeichnet, dass** die Leitschichten (10, 10') aus einem Metall, insbesondere einer Ag/Pd-Legierung oder Pt, bestehen, und dass die Isolierschichten (20) aus einer PZT-Keramik, insbesondere aus Pb (TiₓZr_{y})O₃ mit 0,40 < x < 0,60 bestehen:

10. Piezoelektrischer Keramikkörper nach mindestens einem der vorangehenden Ansprüche, **dadurch gekennzeichnet, dass** in Eckbereichen (13) der Isolierschichten (20) stets Totzonen (11) vorliegen.

## Claims

1. Piezoelectric ceramic body comprising a plurality of superimposed insulating layers (20) with a piezoceramic material, the insulating layers (20) being separated from one another at least in certain regions by a conductive layer (10, 10') with an electrode material, at least the insulating layers (20) having at least approximately an n-agonal shape in plan view, n being equal to 6, 8 or 10, and the conductive layers (10, 10') covering the insulating layers (20) in each case to such an extent that two adjacent insulating layers (20) are in direct contact with each other only in the region of narrow neutral zones (11) that are present in certain regions at the outer edge of the insulating layers (20), **characterized in that** the number of sides with a neutral zone (11) at the edge of the n-gon is equal to the number of sides with a contact region (12), contact regions (12) and neutral zones (11) alternating from side to side.

2. Piezoelectric ceramic body according to Claim 1, **characterized in that** the n-gon is at least approximately a regular n-gon.

3. Piezoelectric ceramic body according to Claim 1, **characterized in that** the corners of the n-gon are at least partially rounded.

4. Piezoelectric ceramic body according to Claim 1, **characterized in that** the superimposed insulating layers (20) produce a ceramic body (5) in the form of a hexagonal prism.

5. Piezoelectric ceramic body according to Claim 1, **characterized in that** the conductive layers (10, 10') cover the insulating layers (20) in each case to such an extent that the conductive layers (10, 10') reach in certain regions up to the edge of the insulating layers (20).

6. Piezoelectric ceramic body according to Claim 1, **characterized in that** the conductive layer (10, 10') covers the insulating layer (20) under it in each case to such an extent that the conductive layer (10, 10') reaches up to the edge of the n-gon, at least in the region of one side (12) of the n-gon formed by the insulating layer (20), and **in that** the edge of the insulating layer (20) is formed by a neutral zone (11) at least in the region of the two sides (12) of the n-gon that are adjacent to the one side of the n-gon.

7. Piezoelectric ceramic body according to Claim 1 or 6, **characterized in that** the neutral zone (11) has a width of from 30 µm to 1 mm, in particular 100 µm to 400 µm.

8. Piezoelectric ceramic body according to at least one of the preceding claims, **characterized in that** the conductive layers (10, 10') between the insulating layers (20) are formed in such a way that a first electrode provided on a side face (12') of the prism formed by the ceramic body (5) is in each case only in electrically conducting connection with every second conductive layer (10'), and **in that** a second electrode, provided on another side face (12' ') of the prism formed by the ceramic body (5), is in each case only in electrically conducting connection with the remaining conductive layers (10) that are not contacted by means of the first electrode.

9. Piezoelectric ceramic body according to at least one of the preceding claims, **characterized in that** the conductive layers (10, 10') consist of a metal, in particular an Ag/Pd alloy or Pt, and **in that** the insulating layers (20) consist of a PZT ceramic, in particular of Pb(TiₓZr_{y})O₃ with 0.40 < x < 0.60.

10. Piezoelectric ceramic body according to at least one of the preceding claims, **characterized in that** neutral zones (11) are always present in corner regions (13) of the insulating layers (20).

## Revendications

1. Corps en matière céramique piézoélectrique comprenant un ensemble de couches isolantes (20) superposées en une matière piézocéramique, les couches isolantes (20) étant séparées au moins par zones, les unes des autres par une couche conductrice (10, 10') en une matière d'électrode,
au moins les couches isolantes (20) ayant en vue de dessus au moins sensiblement la forme d'un polygone à n sommets, n étant égal à 6, 8 ou 10 et
les couches conductrices (10, 10') couvrant dans une large mesure, les couches isolantes (20) de façon que deux couches isolantes voisines (20) ne soient directement en contact les unes avec les autres que dans la région des zones mortes (11), étroites, qui se trouvent par endroits au bord extérieur des couches isolantes (20),
**caractérisé en ce que**
le nombre des côtés ayant une zone morte (11) au bord du polygone à n sommets est égal au nombre de côtés ayant une zone de contact (12), les zones de contact (12) et les zones mortes (11) alternant d'un côté à l'autre.

2. Corps en céramique piézoélectrique selon la revendication 1,
**caractérisé en ce que**
le polygone à n sommets est au moins sensiblement un polygone régulier à n sommets.

3. Corps en céramique piézoélectrique selon la revendication 1,
**caractérisé en ce que**
les sommets du polygone à n sommets sont au moins en partie arrondis.

4. Corps en céramique piézoélectrique selon la revendication 1,
**caractérisé en ce que**
les couches isolantes (20), superposées d'un corps en céramique (5) ont la forme d'un prisme debout.

5. Corps en céramique piézoélectrique selon la revendication 1,
**caractérisé en ce que**
les couches conductrices (10, 10') couvrent dans une très large mesure les couches isolantes (20) de façon que les couches conductrices (10, 10') arrivent par zones jusqu'au bord des couches isolantes (20).

6. Corps en céramique piézoélectrique selon la revendication 1,
**caractérisé en ce que**
la couche conductrice (10, 10') couvre très largement la couche isolante (20) qui se trouve en dessous de façon que la couche conductrice (10, 10') arrive au moins au niveau d'un côté (12) du polygone à n sommets formé par la couche isolante (20) jusqu'au bord du polygone à n sommets et
au moins dans la région des deux côtés (12) voisins des côtés du polygone à n sommets, le bord de la couche isolante (20) est formé par une zone morte (11).

7. Corps en céramique piézoélectrique selon la revendication 1 ou la revendication 6,
**caractérisé en ce que**
la zone morte (11) a une largeur de 30 µm jusqu'à 1 mm et notamment 100 µm jusqu'à 400 µm.

8. Corps en céramique piézoélectrique selon au moins l'une des revendications précédentes,
**caractérisé en ce que**
les couches conductrices (10, 10') sont réalisées entre les couches isolantes (20) de façon qu'une première électrode réalisée sur une surface latérale (12') du prisme formé par le corps en céramique (5), ne soit en liaison électroconductrice chaque fois seulement qu'avec chaque seconde couche conductrice (10') et qu'une seconde électrode appliquée sur une autre face latérale (12") du prime constitué par le corps en céramique (5), soit en liaison électroconductrice seulement avec les autres couches conductrices (10) restantes, qui ne touchent pas la première électrode.

9. Corps en céramique piézoélectrique selon au moins l'une des revendications précédentes,
**caractérisé en ce que**
les couches conductrices (10, 10') sont en un métal, notamment en un alliage Ag/ Pd ou Pt et
**en ce que** les couches isolantes (20) sont en une céramique PZT, notamment en Pb (TiₓZr_{y})O₃ dans laquelle 0,40 < x < 0,60.

10. Corps en céramique piézoélectrique selon au moins l'une des revendications précédentes,
**caractérisé en ce que**
dans les zones de sommets (13) des couches isolantes (20), il y a toujours des zones mortes (11).
